# EUROPEAN PATENT APPLICATION

(11) **EP 4 722 410 A1**
(43) Date of publication of application: **08.04.2026**
(21) Application number: 25193665.4
(22) Date of filing: 04.08.2025
(51) Int. Cl.: C23C 16/44, C23C 16/32, C30B 29/36, C30B 1/00, C30B 25/02, B08B 7/00, H01J 37/32, C30B 25/00, H10P 14/60, H10P 72/00

(54) **ETCHING OF SILICON CARBIDE FILMS FROM REACTOR PARTS**

(30) Priority: 06.08.2024 IT 202400018535; 27.06.2025 IT 202500015637
(71) Applicant: LPE S.p.A., 20021 Baranzate (MI) (IT)
(72) Inventor: VALENTE, Gianluca, 20021 Baranzate (MI) (IT); MICARD, Quentin, Catania (IT); CRIPPA, Danilo, Novara (IT)
(74) Representative: Buzzi, Notaro & Antonielli d'Oulx S.p.A.

(57) **Abstract**

The present invention relates to a method for etching a silicon carbide accretion from one or more workpieces of a reaction chamber for the deposition of silicon carbide layers on a substrate. The method comprises the steps of: (I) providing a silicon carbide accretion on one or more workpieces of a reaction chamber of a reactor for deposition of silicon carbide; (II) executing at least one cycle of an etching process. The present invention further relates to a reactor adapted to execute said method.

## Description

### FIELD OF INVENTION

The present invention relates to the field of epitaxial deposition of semiconductor accretions on substrates; in particular to a method and to a reactor adapted to execute a chemical etching of silicon carbide from reactor workpieces.

### BACKGROUND OF THE DISCLOSURE

During epitaxial deposition processes, one or more monocrystalline semiconductor layers grow in a controlled fashion on one or more rotating substrates. However, during this process, undesired semiconductor accretions may also simultaneously grow on other parts of the reaction chamber exposed to process gases.

Indeed, during the epitaxial deposition of monocrystalline silicon carbide on a substrate, for instance the epitaxial deposition of 3C, 4H or 6H silicon carbide polytypes, users typically observe uncontrolled silicon carbide build-up on structural and functional parts of the reaction chamber, referred hereinafter as "workpieces". It is noted that this undesired silicon carbide build-up is very difficult to remove because of the hardness of the material, and conventional techniques used in the silicon semiconductor industry do not suitably apply to the removal of silicon carbide parasitic deposits.

Contrary to the orderly monocrystalline layers deposited on the substrate, silicon carbide accretions generally comprise silicon carbide in polycrystalline and/or amorphous form. Typically, the accretions are a mixture of both polycrystalline and amorphous silicon carbide. The latter may compose up to 20 - 60% of the total, as can be observed in XRD measurements, though the relative ratio of the two forms may be subject to relevant local and average variations.

The above parasitic phenomenon is particularly relevant in hot-wall reactors, where it is prevalently impacting the upstream end of the chamber (i.e., where the precursor gases enter the reaction chamber), as well as the elements surrounding or in contact with the substrate.

It is noted that undesired SiC buildup does not occur only on bare surfaces of the reaction chamber but also on workpieces that are preventively coated.

Indeed, reaction chamber parts made in graphite may be coated with a TaC layer to protect the graphite surfaces during cleaning operations. Alternatively, a thin coating of SiC may be used to seal the exposed porous graphite surfaces to avoid contamination. In this case, the SiC coating used on the graphite workpieces is in polycrystalline form, with a smooth external surface having surface roughness well below 6,3 µm Ra, typically below 1 µm Ra.

It has been observed that the parasitic deposition of SiC accretions on reaction chamber workpieces often results in the rapid growth of cauliflower-like, porous, dendritic-like structures, which eventually affect the quality of the deposited layers on the semiconductor substrates. These parasitic accretions have an uneven appearance, with macroscopic rugosity.

In order to prevent the negative effects of parasitic accretions on the deposition process, the reaction chamber is subject to frequent Preventive Maintenance (PM) operations, for instance after every 100 µm to 2000 µm of total epitaxial layers growth.

During PM, the machine is cooled and purged, and some or all affected workpieces are manually removed from the chamber for mechanical cleaning, disposal, and/or substitution.

PM operations negatively impact the productivity of the reactor, thereby heavily affecting the economics of the epitaxial deposition process. Indeed, PM operations currently cause several hours of reactor downtime and are typically carried out at least once or twice a week.

In silicon reactors, in-situ or ex-situ chemical etching processes are used to remove undesired Si parasitic deposits. These methods allow more reproducible results than their mechanical cleaning counterparts. Additionally, in-situ etching processes can be performed without the need to open and access the reaction chamber of the reactor, advantageously reducing reactor downtime and streamlining operations.

However, silicon carbide exhibits very different chemical and physical properties compared to silicon. It is a much harder material, difficult to attack via chemical means without eventually damaging the concerned reactor workpieces, typically made of graphite, and/or introducing potential contaminants into the chamber.

It is noted that in-situ etching is generally conducted using chemicals that react with the parasitic deposits, leading to gas phase byproducts. In the case of Silicon Carbide, this process may lead to both gas phase and solid, powder-like byproducts.

Presence of powder-like byproducts of the etching process in the reaction chamber may affect the quality of the epitaxial deposition process. However, they may be difficult to remove without significant extension of etching times, which may damage the underlying chamber parts and negatively impact reactor downtime.

While methods for etching SiC have been disclosed in the art, these methods typically discuss the removal of a few top layers of orderly SiC from bulk SiC pieces, such as described in US20140030892A1 and US20060001028A1. The chemical etching of SiC in these instances takes place in the absence of an underlying workpiece (of potentially different composition) that may be damaged in the process. These processes typically remove only few microns of SiC, to respectively reduce warpage of monocrystalline SiC substrates and surface cracks of SiC substrate holders. These methods do not address the removal of disorderly parasitic SiC deposits without detriment to the affected workpieces.

It is therefore desirable to provide a new method for etching polycrystalline-amorphous SiC parasitic build-up from the affected workpieces of a reaction chamber without damaging said workpieces.

It is also desirable to provide a method for etching polycrystalline/amorphous SiC parasitic build-up that may be performed *in-situ,* i.e., directly in the reaction chamber without opening the latter and/or extracting it from the reactor.

Additionally, it would be desirable to provide a new reactor adapted to execute the above-mentioned method. Furthermore, it would be desirable to provide a reactor configured to execute said method in an automated fashion.

### SUMMARY OF THE DISCLOSURE

This summary is provided to introduce a selection of concepts in a simplified form. These concepts are described in further detail in the detailed description of example embodiments of the disclosure below. This summary is not intended to identify key features or essential features of the claimed subject matter, nor is it intended to be used to limit the scope of the claimed subject matter.

It is an object of the present invention to overcome the disadvantages of the prior art.

In particular, it is an object of the present invention to provide a method that may etch polycrystalline/amorphous SiC accretions from affected workpieces of a reaction chamber without damaging said workpieces. It is a further object of the present invention to provide a new method that may etch polycrystalline/amorphous SiC accretions, which may be performed in-situ.

It is a further object of the present invention to provide a reactor which may be adapted to execute said new method, optionally in an automated fashion.

The main objectives hereinbefore described are achieved through the invention recited in the appended claims, which constitute an integral workpiece of the present description.

It is noted that the use of reference signs in the claims, if any, does not limit their scope. The sole purpose of reference signs is to make the claims easier to understand.

### BRIEF DESCRIPTION OF THE FIGURES

The illustrations presented herein are not meant to be actual views of any particular material, structure, or device, but are merely idealized representations that are used to describe embodiments of the disclosure.
FIG. 1 illustrates the method according to the invention in accordance with one embodiment.t.
FIG. 2 illustrates the method according to the invention in accordance with one embodiment.
FIG. 3 illustrates the method according to the invention in accordance with one embodiment.
FIG. 4 illustrates the method according to the invention in accordance with one embodiment.
FIG. 5 illustrates the method according to the invention in accordance with one embodiment.
FIG. 6 details a routine of the method according to the embodiment illustrated in FIG. 5.
FIG. 7 illustrates a view in the transverse plane XY of a reaction chamber adapted to execute the method of the invention in accordance with one embodiment.
FIG. 8 illustrates a lateral view in the longitudinal plane XZ of the reaction chamber of FIG. 7.
FIG. 9 illustrates a scheme of a reactor in accordance with one embodiment.
FIG. 10 is a picture of a workpiece with a silicon carbide accretion.

### DETAILED DESCRIPTION OF EXEMPLARY EMBODIMENTS

Although certain embodiments and examples are disclosed below, it will be understood by those in the art that the invention extends beyond the specifically disclosed embodiments and/or uses of the invention and obvious modifications and equivalents thereof. Thus, it is intended that the scope of the invention disclosed should not be limited by the particular disclosed embodiments described below.

Reference will now be made to the Figures wherein like reference numerals identify similar structural features or aspects of the subject disclosure.

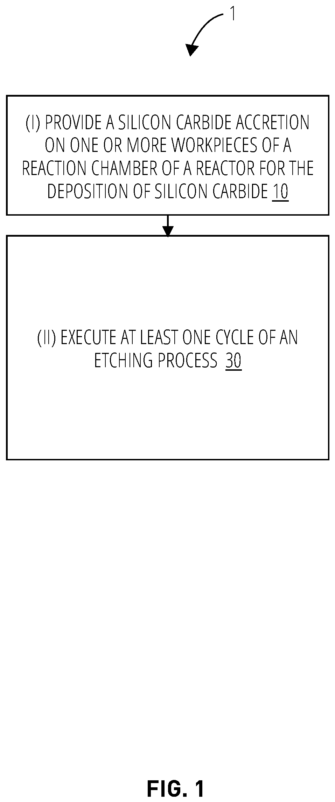

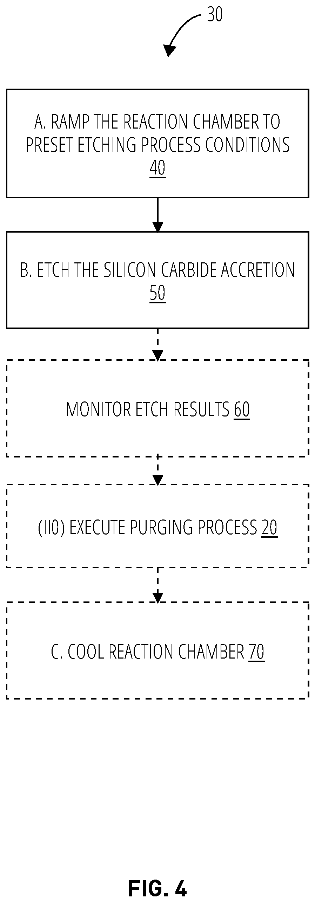

In FIG. 1 - FIG. 6, optional steps and sub-steps are distinguished from essential steps and sub-steps by the use of a dashed line instead of a solid line.

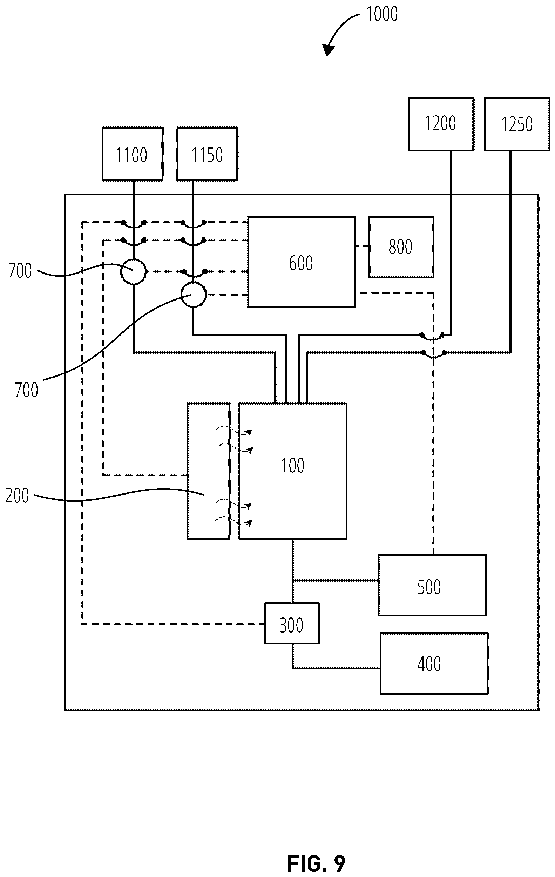

In FIG. 9, all connections of digital signals are indicated as dashed lines. Physical connections are indicated by solid lines.

It will be appreciated that elements in the figures are illustrated for simplicity and clarity. In particular some elements or steps may have been omitted or may have not necessarily been drawn to scale. For example, the dimensions of some elements in the figures may be exaggerated relative to other elements to help improve understanding of illustrated embodiments of the present disclosure.

Under a first aspect, the present invention relates to a method 1 for etching a silicon carbide accretion 121 from one or more workpieces 120 of a reactor 1000 suitable for the epitaxial deposition of monocrystalline silicon carbide layers on a substrate.

By "etching" it is meant chemical etching in gaseous phase.

Method 1 comprises steps (I)-(II), listed below.

In step (I), a SiC accretion is provided on one or more workpieces of a reaction chamber of a reactor for the deposition of silicon carbide (block 10).

In step (II), at least one cycle of an etching process is executed (block 30, FIG. 1 - FIG. 5). The etching process allows the chemical cleaning/removal of the SiC accretion provided in step (I).

The etching process comprises the consecutive steps, or phases, of:
A. ramping the reaction chamber to preset etching process conditions;
B. etching the silicon carbide accretion; and
C. performing an optional cooling step.

Steps A, B, and C are respectively set forth in block 40, block 50 and block 70.

Specifically, step A comprises the following sub-steps:
A1. ramping the temperature T_{R} of the reaction chamber to 500 - 1450 °C;
A2. ramping the pressure of the reaction chamber to 50-1000 mbar;
A3. optionally flowing an inert gas into the reaction chamber, which may help to reach and maintain the desired temperature and pressure conditions.

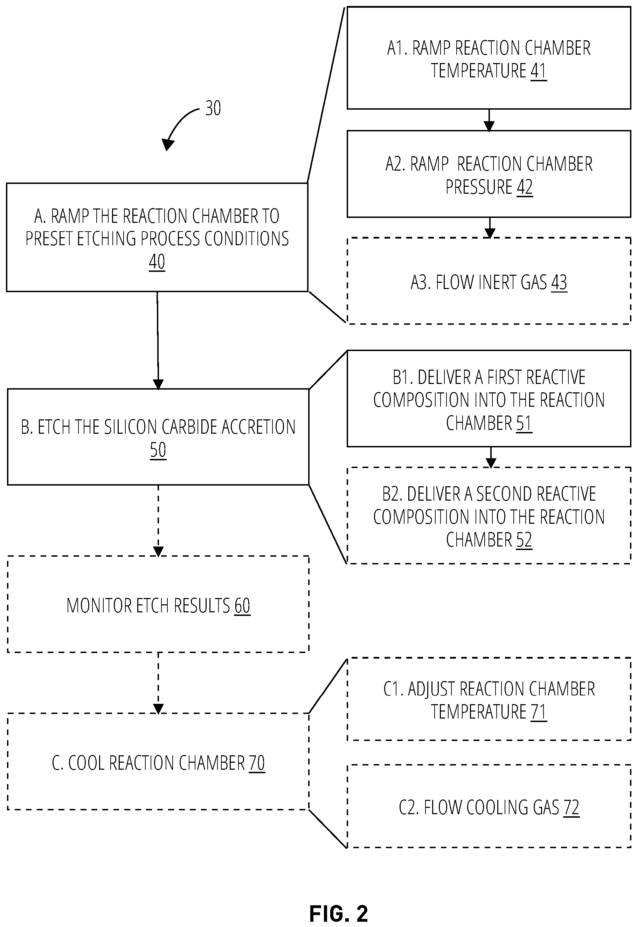

All sub-steps A1-A3 above (respectively set out in blocks 41, 42, and 43 of FIG. 2), whether mandatory or optional, may be performed in any order, including simultaneously.

Step A. is performed by gradually adjusting pressure and temperature conditions from a starting value to the desired process value, thereby protecting the reaction chamber from the undesired effects of abrupt changes, which may cause stress and damage to mechanical parts, and/or cause lack of uniformity of process conditions inside the reaction chamber.

Once the reaction chamber has reached the desired temperature and pressure settings, the actual etching of the SiC parasitic accretion can take place according to step B.

Step B comprises the sub-step B1 of:
B1. delivering a first reactive composition into the reaction chamber (block 51).

The first reactive composition comprises one or more reactive gases, i.e., gases suitable to react with Si and/or C for etching purposes. In particular the reactive composition comprises at least a first reactive gas.

The first reactive gas is a halogen or a halogen compound.

Under an embodiment, if the first reactive gas is a halogen compound, the compound is a hydrogen halide.

Under an embodiment, if the first reactive gas is a halogen compound, the halogen compound is not a metal halide, an interhalogen compound, an organohalogen compound, nor a polyhalogenated compound.

The first reactive composition also comprises a carrier gas; which is preferably an inert gas. For example, the inert gas may be nitrogen, helium, or argon to avoid contamination of the chamber. The carrier gas may advantageously be used to tailor and control the concentration and distribution of reactive gases in the chamber.

The halogen or halogen compound may be delivered in the reaction chamber in a molecular, radical, and/or ionized state, such as, but not limited to, a plasma state.

In a non-limiting example, radicals and/or ions of the first reactive gas may be formed from molecular halogen or halogen compounds inside the reaction chamber, by virtue of the temperature and pressure conditions inside the chamber, and/or under an RF alternating electric field.

Alternatively, radicals and/or ions of the first reactive gas may be formed immediately outside the reaction chamber, under specific conditions of temperature, pressure, illumination, and/or electric field.

The inventors have observed that the molar concentration of the first reactive gas into the carrier gas should be equal to 15 - 40%. Surprisingly, by selecting this concentration, under the temperature and pressure conditions set forth above, it is possible to remove the parasitic SiC deposits without detriment to the coated/uncoated graphite parts concerned. The removal of the parasitic SiC deposits is not necessarily carried out until reaching 100% removal. Advantageously, deposits may be removed to a degree suitable to recreate adequate operating conditions inside the reaction chamber, thereby extending operation time in between PM operations.

The SiC accretion referred to above and in the following is directly obtained or obtainable as parasitic deposition of silicon carbide on reaction chamber parts (workpieces) during a standard epitaxial deposition process, where SiC layers are deposited on a rotating substrate inside the reaction chamber.

The SiC accretion is therefore a by-product of one or more epitaxial deposition processes of monocrystalline SiC layers on a rotating substrate, where said process is executed in the reaction chamber of a reactor. The by-product is formed on one or more workpieces of the reaction chamber, surrounding the substrate and exposed to process gases.

It is noted that the technical properties of the SiC accretion imparted by the parasitic build up process cab be adequately defined only in terms of the parasitic process per se. While the latter certainly imparts recognizable features, such as unevenness of the accretion and rugosity, it would be unduly limiting to characterize the SiC accretion in terms of said features.

These workpieces are typically not made of monocrystalline Sic, and as a result the SiC accretion is not monocrystalline but comprises silicon carbide in polycrystalline and/or amorphous form. The present method is not limited by the specific solid-state properties of the SiC accretion. The latter typically comprises or consists of a mixture of both polycrystalline and amorphous SiC, for example a mixture of polycrystalline SiC with 20 - 60% of amorphous SiC. The amount of amorphous SiC in the accretion may be subject to significant local and absolute variations.

The SiC layers being deposited are usually monocrystalline. They are generally, though not exclusively, of the 3C, 4H or 6H polytypes.

The parasitic SiC deposits are well-known undesired by-products of the SiC layer deposition.

The parasitic SiC deposits occur on the surface of all parts of the reaction chamber exposed to the gas flow of SiC precursors, and especially at the upstream end of the chamber (i.e., where the precursor gases enter the reaction chamber), as well as on the elements in proximity or in contact with the substrate.

In particular, the workpieces affected by parasitic deposition are removable and fixed parts of the reaction chamber (covers, rings, walls), whether stationary or rotating, as the result of their exposure to SiC precursor gases during the deposition process.

These workpieces are often made of material with a much lower hardness compared to SiC, such as coated or bare graphite.

The parasitic deposition of SiC is a phenomenon particularly, though not exclusively, impacting hot-walls reaction chambers. The high temperatures of the walls and of the other parts of the reaction chamber favor parasitic build-up.

Therefore, here and in the following, the expression "SiC accretion" shall be deemed equivalent to "parasitic SiC film" or "SiC film" or "parasitic SiC deposits," unless otherwise specified, and will refer to SiC in polycrystalline and/or amorphous form.

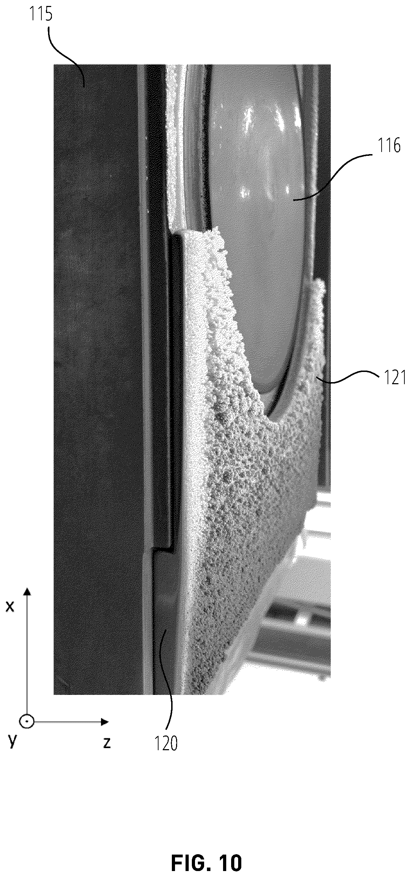

Furthermore, the term "accretion" in the expression "SiC accretion" or "silicon carbide accretion" (as well as the term "film" in the expression "parasitic SiC film" or "SiC film") shall not imply a bi-dimensional regular and/or orderly geometry. On the contrary, it may refer to an uneven SiC coating formed on one or more surfaces of impacted parts of the reaction chamber and may exhibit a three-dimensional structure, such as a rough gritty surface, as evident from FIG. 10.

The term "accretion" (or "film") and the term "layer" are used here and in the following to respectively distinguish the undesired parasitic SiC deposits from the desired, controlled SiC layers deposited on a substrate.

In general, the parasitic SiC accretion exhibits an uneven surface, for instance with apparent rugosity and variable thickness. The unevenness of the surface, often clearly visible to the naked eye, is usually, but not necessarily accompanied by a cauliflower-like or fractal-like structure, with visible macroscopic dips and protrusions, possibly due to a dendritic-like growth process.

This phenomenon is especially visible and affecting the quality of deposited layers when the reaction chamber runs for 100 µm to 2000 µm of total monocrystalline SiC deposition (on one same substrate or on a plurality of consecutively treated substrates without a PM cycle in between), for instance when it runs for 200 - 800 µm of total monocrystalline SiC deposition.

In this case, the parasitic growth can be etched in a particularly satisfactory manner with the present method.

The present method can be satisfactorily used also for a wider range of total monocrystalline SiC deposition, such as 10 µm - 2000 µm, preferably 50 µm - 2000 µm, preferably 100 µm - 2000 µm, even more preferably 100 - 800 µm.

FIG. 10 shows a picture of a parasitic SiC accretion 121 on a workpiece 120, positioned on the lower partition 115 of a reaction chamber 100. The workpiece 120, which is an upstream cover, partially surrounds the receiving area 116, which is adapted to host a 6" substrate. The parasitic SiC deposit appears lighter in color in the grayscale picture compared to the other visible parts of the reaction chamber, which are made of graphite. The accretion 121 coats the surface of the workpiece 120 exposed to precursor gases with an uneven, granular, and gritty film.

The irregular features of the parasitic accretion become more pronounced the longer the reaction chamber workpiece is exposed to the flow of precursor gases.

The silicon carbide accretion of the invention may exhibit a surface roughness greater than 6,3 µm Ra.

Under an embodiment, the optional cooling step C, to be performed after step B, comprises the following sub-steps of:
C1. cooling the reaction chamber to a temperature T_{c} < T_{R}, and in any case with T_{c} < 1000 °C (block 71), for example with T_{c} between 500 - 900 °C; and
C2. flowing a cooling gas to reach a pressure of 100 - 1000 mbar inside the reaction chamber (block 72).

Sub-steps C1 and C2 may be performed in any order, preferably simultaneously.

Sub-step C1 may be performed by turning off the heating source and allowing the reaction chamber to cool, mostly via radiation. Sub-step C1 may be sped up by running sub-step C2 simultaneously.

The cooling gas employed in sub-step C2 is any gas suitable to speed up the cooling process of the chamber to idle temperature. The person with average skill in the art might easily select the most suitable gas depending on budget and time constraints. Non-limiting examples of cooling gases include helium, nitrogen, hydrogen, and combinations thereof.

FIG. 2 summarizes all steps A, B and C discussed above for step (II), block 30, together with their respective sub-steps.

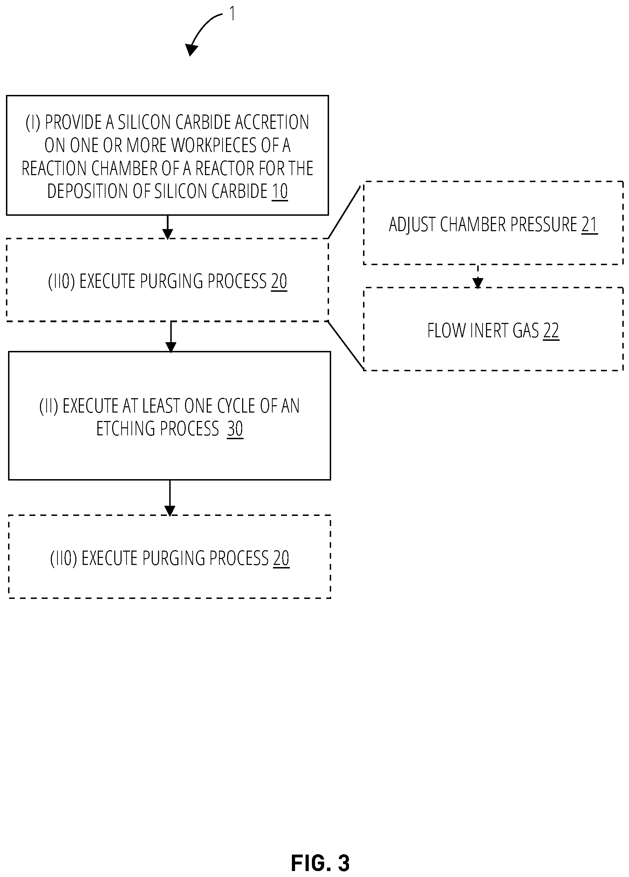

Under an embodiment, the method 1 of the invention may comprise a purging step (II0) of the reaction chamber, to be executed after step (I), and illustrated in FIG. 3. The purging step is set forth in block 20 and comprises the execution of 1 - 20 cycles of a purging process, which may clean the reaction chamber from the residues of other operations/processes carried out therein.

During the purging process the following sub-steps (block 21 and block 22) are sequentially executed starting from either sub-step below:
- adjusting the pressure of the reaction chamber to ≤ 1 mbar; and
- flowing an inert gas to reach a pressure of 100 - 1000 mbar inside the reaction chamber.

Step (II0) may be conducted before step A.

Alternatively, it can be executed after step B, and before or after step C if present. This may beneficially remove all traces of the reactive gases used, as well as any by-products of the etching process that may still be present in the chamber.

The cooling step C may be advantageously used to set up favorable conditions to execute the optional purging process, and/or the latter may help achieve the effects of the cooling step C more efficiently, depending on the order in which they are executed.

In conclusion, the optional purging process may be executed: 1) before step A; 2) after step B, 3) after step B and before step C as an additional step of the etching process, or 4) after both step B and C, once the etching process is concluded.

Under an embodiment, the flow rate of the first reactive gas is 0.5 - 2.3 mol/(s·m²).

Under an embodiment, step (I) of the method according to the invention is performed by executing one or more epitaxial deposition cycles of monocrystalline SiC layers on the same or different substrate inside a reaction chamber of a reactor, until reaching a predefined total thickness T_{z} of monocrystalline SiC layers deposited on one or more consecutive substrates during the entire operation time of the chamber.

In this case, T_{z} is preferably 10 µm - 2000 µm, preferably 50 µm - 2000 µm, preferably 100 µm - 2000 µm, even more preferably 100 - 800 µm, even more preferably 200 - 800 µm, even more preferably 500 - 700 µm.

During this step, a parasitic SiC accretion of variable and uneven thickness is formed on one or more workpieces of the reaction chamber. The SiC accretion thus obtained is said to have an "equivalent thickness" T_{z}, i.e., a thickness obtained as the result of depositing orderly layers of total cumulative thickness T_{z}.

It is noted that the local thickness of the parasitic accretion may greatly vary and differ on average from T_{z}.

It is noted that the peaks of the parasitic accretion may be significantly higher than the thickness T_{z}, because of the dendritic-like growth of the accretion.

Under an embodiment, the etching process of the method according to the invention is executed for 0.10-0.6 minutes per µm of the predefined total thickness T_{z}.

Under an embodiment, the method according to the invention is executed for 0,1 - 0,6 minutes per µm of the predefined total thickness T_{z}.

Under an embodiment, the method according to the invention is executed for 0,3 - 0,55 minutes per µm of the predefined total thickness T_{z}.

As previously discussed, in the art the equivalent thickness of a parasitic accretion is not its average or maximum thickness since the latter may be subject to significant local variation. The equivalent thickness of a parasitic accretion coincides with the thickness of the monocrystalline layers deposited on one or more substrates during one or more consecutive deposition processes. As the orderly monocrystalline layers grow on a substrate, the parasitic accretion grows on certain workpieces of the reaction chamber, with variable elevation. It is therefore more meaningful to refer to its equivalent thickness, which is a parameter set and controlled during the reactor operation, and which can be easily measured on the actual substrates after the deposition process.

Under an embodiment, the workpieces of the reaction chamber to be etched are made of graphite, optionally coated with mono- or poly-crystalline silicon carbide with a rugosity < 6,3 µm Ra, pyrolytic graphite, mono- or poly-crystalline diamond, quartz, and/or boron nitride.

The coatings described above may help preserve the graphite workpieces during preventive maintenance operations and during the etching process. They may also prevent contamination of the reaction chamber during the deposition process.

Graphite workpieces coated with mono- or poly-crystalline diamond have been observed to work particularly well in the execution of the invention, in particular when the first reactive gas comprises or consists of fluorine atoms, molecules or radicals.

Graphite workpieces coated with pyrolytic graphite have been observed to work particularly well in the execution of the invention, in particular when the first reactive gas comprises or consists of chlorine atoms, molecules or radicals.

Under an embodiment, the first reactive gas may be chosen from the group consisting of F₂, ClF, ClF₃, ClF₅, Cl₂, HCl, XeF₂, XeF₄, XeF₆, XeO₃, KrF₂, Br₂, I₂, and HBr.

Under an embodiment, the first reactive gas is F₂, ClF, ClF₃, or ClF₅, and step A1 is executed at a temperature (T_{R}) of 500-1000 °C.

Alternatively, the first reactive gas is Cl₂ or HCl, and:
- step A1 is executed at a temperature (T_{R}) of 1000 - 1450 °C, preferably at a temperature of 1150 - 1350 °C; and/or
- step A2 is executed at a pressure of 50 - 700 mbar, preferably 150 - 700 mbar.

Under an embodiment, in step A1, the temperature of the reaction chamber is adjusted to 1150 - 1350 °C.

Surprisingly, in this temperature range the ratio of Si and C etching by radicals of the first reactive gas is optimized with respect to the overall etching process itself. The higher the temperature, the more prevalent the Si etching becomes, but at lower temperatures the etching process is overall less effective.

With great advantage, the method described above can be used for the in-situ and ex-situ etching of SiC accretions from one or more workpieces of a reaction chamber.

When the first reactive gas is a halogen, the latter is preferably selected with a purity equal to or greater than 99.990%, even more preferably with a purity equal to or greater than 99.998%.

It is noted that during the etching process, because of the pressure and temperature conditions inside the reaction chamber, the halogen molecules form radicals, which attack the SiC accretion thereby creating by-products of the etching process. These by-products are then discharged out of the reaction chamber.

Under the process conditions laid out in the present disclosure, the method according to the invention allows a suitable removal of both carbon and Si of the parasitic SiC deposits. The removal is adequate for the purpose of resuming deposition operations, thereby extending the operating lifetime of a reaction chamber between successive PMs.

For what concerns the in-situ etching applications, the possibility to chemically clean the reaction chamber after parasitic build-up and to set it in adequate operating conditions without the need to: (a) open the reactor, (b) remove the reaction chamber, and (c) expose its parts to air for cleaning, is a considerable improvement with respect to the current mechanical cleaning techniques.

Surprisingly, despite the unique and challenging properties of SiC, it is possible to effectively remove up to hundreds of microns of hard, disorderly parasitic deposits without damaging the parts of the reaction chamber.

The above method answers the long-felt need in the industry of providing a method for in-situ cleaning the reaction chamber of a SiC reactor from parasitic deposits.

Under an embodiment, the first reactive composition used in step B1 comprises a second reactive gas.

For example, the second reactive gas is an oxidizing agent or a reducing agent.

The second reactive gas may be delivered in the reaction chamber in a molecular, radical, and/or ionized state, such as, but not limited to, a plasma state.

In a non-limiting example, radicals and/or ions of the second reactive gas may be formed from molecular halogen or halogen compounds inside the reaction chamber, by virtue of the temperature and pressure conditions inside the chamber, and/or under an RF alternating electric field.

Alternatively, radicals and/or ions of the second reactive gas may be formed immediately before entering the reaction chamber, under specific conditions of temperature, pressure, illumination, and/or electric field.

A non-limiting example of reducing agent is H₂.

By oxidizing agent, it is meant an oxygen compound, an oxygen molecule, or an oxygen radical.

Examples of the oxidizing agent that have been observed to work particularly well in the execution of the invention are: N₂O, NO, N₂O₂, O₂, O₃, and H₂O₂.

The use of a second reactive gas in the first reactive composition may allow targeting (or preventing the formation of) undesired by-products of the reaction from the first reactive gas and the SiC accretion.

Under an embodiment, the first reactive gas and the second reactive gas in the first reactive composition are respectively chosen from the group consisting of the following pairs: HCl and N₂O, HCl and O₃, HCl and H₂O₂, HCl and O₂, Cl₂ and O₂, Cl₂ and O₃, Cl₂ and H₂O₂, HCL and H₂, and HCl and HF.

Under an embodiment, the molar concentration of the second reactive gas into the carrier gas is 0.1-20%.

Under an embodiment, the molar concentration of the second reactive gas into the carrier gas is 0.1-15%.

Under an embodiment, the molar concentration of the second reactive gas into the carrier gas is 1 - 10%.

It has been surprisingly observed that the use of a halide with an oxidizing agent is particularly effective in removing undesired byproducts, without detriment to the underlying workpiece and without generating solid, powder-like residues.

Under an embodiment, the first reactive composition used in step B1 comprises a third reactive gas.

Under an embodiment, step B further comprises the sub-step of:
B2. delivering a second reactive composition into the reaction chamber; where the second reactive composition comprises one or more reactive gases and a carrier gas (block 52).

In this case, the carrier gas is an inert gas; and the one or more reactive gases comprise at least an oxidizing agent.

It is noted that sub-step B2 may be conducted before or after sub-step B1.

In case sub-step B2 is conducted before sub-step B1, the oxidizing agent may leave a Si rich by-product suitable to be removed via suction or by reacting with the halogen or halogen compound, especially a fluorine-based molecule or fluorine compound.

Under an embodiment, sub-step B2 is conducted after sub-step B1.

Under an embodiment, the molar concentration of the oxidizing agent into the carrier gas is 0.1 - 20%.

Under an embodiment, the molar concentration of the oxidizing agent into the carrier gas is 0.1-10%.

Under the above-mentioned conditions, the oxidizing agent can effectively remove any carbon rich byproducts left by the first reactive composition.

A purging step may optionally be carried out between sub-steps B1 and B2, or between sub-steps B2 and B1, depending on their order.

Under an embodiment, step B1 comprises the following sub-steps:
- optionally venting the one or more reactive gases and/or the carrier gas. By "venting" it is meant bypassing the reaction chamber for a preset amount of time;
- ramping the one or more reactive gases and the carrier gas to a respective preset nominal flowrate;
- delivering the one or more reactive gases and the carrier gas into the reaction chamber at said preset nominal flowrate.

The sub-steps above may feature different or same start and/or duration times for each of the one or more reactive gases and for the carrier gas.

For instance, the first reactive gas may be subject to a ramp time TR1 and a time at constant value TS1, and the inert gas may be subject to a ramp time TR2 and a time at constant value TS2, and TR1, TS1, TR2, TS2 may differ from each other. The start of the ramp time for Cl₂ and for the inert gas may differ, and they may be subject to optional and different vent times.

It is noted that all parameters mentioned in this embodiment may be provided as an input from the user or be a predefined setting. The predefined setting may be calculated based on calibration curves provided for a given reactor and on the result to be achieved. They can be obtained by the person with average skill in the art without undue burden and adapted to the specific reaction chamber design in use.

Under an embodiment, the reaction chamber 100 comprises at least one monitoring system 500 adapted to monitor an etching parameter indicative of an endpoint of the etching process.

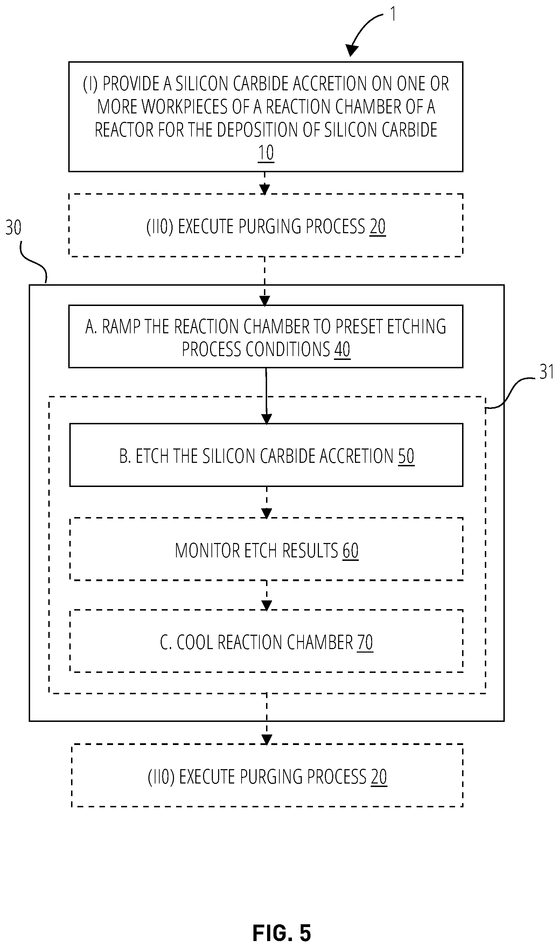

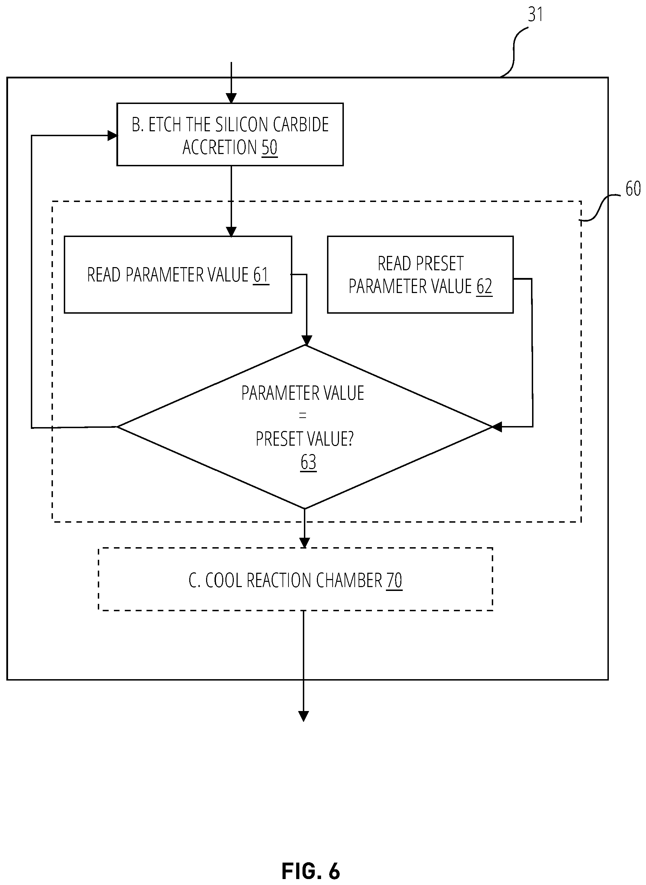

In this case, process B according to the invention further comprises a monitoring step (block 60) (See FIG. 5 and FIG. 6, which shows details of block 31 of FIG. 5).

The monitoring step is executed at the end of step B (namely after step B1 and, if present, after both step B1 and step B2).

The monitoring step comprises the following sub-steps:
- reading a preset target value of the etching parameter (block 62), and optionally a preset tolerance;
- reading the actual value of the etching parameter (block 61);
- checking if the actual value has reached the target value (decision block 63), optionally within said present tolerance;
- repeating step B until reaching said target value (optionally within said present tolerance).

Once the target value is achieved, the monitoring step is concluded. The monitoring system may be a detector suitable to detect the concentration of silicon and/or carbon in the by-product gases generated after each cycle of the etching step B, such as a mass spectrometer.

Advantageously, this embodiment allows to monitor the progress of the method according to the invention.

Under an embodiment, the method according to the invention is executed in-situ to etch the silicon carbide accretion from one or more workpieces of a reaction chamber, i.e., the method is executed when the reaction chamber is positioned inside the reactor, without opening the latter. To this effect, the reaction chamber may be provided with at least one gas inlet and at least one gas outlet apertures.

In this case, during step B a first reactive composition is delivered into the reaction chamber through the at least one gas inlet aperture, thereby forming by-products of the etching process. These by-products may then be advantageously discharged through the at least one gas outlet aperture.

Any residual by-products, if any, may be further etched with a second reactive composition.

Advantageously, the in-situ cleaning of the reaction chamber parts allows to drastically reduce PM times and limits the exposure of operators to the reaction chamber. Said exposure represents a safety concern that requires elaborate and time-consuming safety procedures.

Preferably but not exclusively, the reaction chamber of the present embodiment is an epitaxial reaction chamber.

According to the above embodiment, the invention relates to a method for in-situ etching a SiC accretion from one or more workpieces of a reaction chamber for the deposition of monocrystalline silicon carbide layers on a substrate, the method comprising the steps of:
(I) providing a silicon carbide accretion on one or more parts of a reaction chamber of a reactor for deposition silicon carbide; wherein said reaction chamber is equipped with at least one gas inlet aperture and at least one gas outlet aperture;
(II) executing at least one cycle of an etching process inside the reaction chamber, the etching process comprising the steps of:
   A. ramping the reaction chamber to preset etching process conditions;
   B. etching the silicon carbide accretion.

Step A comprises the sub-steps of:
A1. adjusting the temperature T_{R} of the reaction chamber to 500 - 1450 °C; and
A2. adjusting the pressure of the reaction chamber to 50 - 1000 mbar.

Step B. comprises the sub-step of:
B1. delivering a first reactive composition into the reaction chamber through the gas inlet aperture; where said first reactive composition comprises one or more reactive gases and a carrier gas.

The carrier gas is an inert gas.

The one or more reactive gases comprise at least a first reactive gas, which is a halogen or a halogen compound, and the molar concentration of the first reactive gas into the carrier gas is 15 - 40%.

Advantageously, the method according to the invention allows to reach a removal rate of the silicon carbide accretion of 0.01 - 0.20 g/cm² per hour, without affecting the underlying workpieces of the reaction chamber. The removal rate may be measured during calibration of the method by weighing the affected workpieces before and after deposition, and before and after etching.

In one embodiment, the affected workpieces comprise the upper and lower walls of the chamber, and/or the covers (upstream and/or downstream) of said walls, and/or other elements of the reaction chamber, and/or substrate holders or elements thereof (such as rings).

The present embodiment may be executed in accordance with any other embodiments hereinbefore described.

The method hereinbefore described has been observed to work well with reaction chambers for the deposition of silicon carbide.

For example, without limitation, the reaction chamber may be of the type described in international patent applications published as: WO2004053187, WO2004053188, WO2007088420 and WO2015092525.

For example, without limitation, the reaction chamber may be of the type described in US patent application No.18/953,993.

These designs are affected by parasitic build-up on graphite workpieces.

The parasitic build-up occurs on graphite parts that are critical to preserve. The method according to the invention is effective against parasitic SiC build-up, without damaging the graphite parts underneath, thanks to the specific process conditions herein disclosed.

Preferably, but not exclusively, the method according to the invention may be executed when the reaction chamber is of the hot-wall, epitaxial, horizontal, and/or crossflow type.

In any event the present invention is not limited to a specific reaction chamber design.

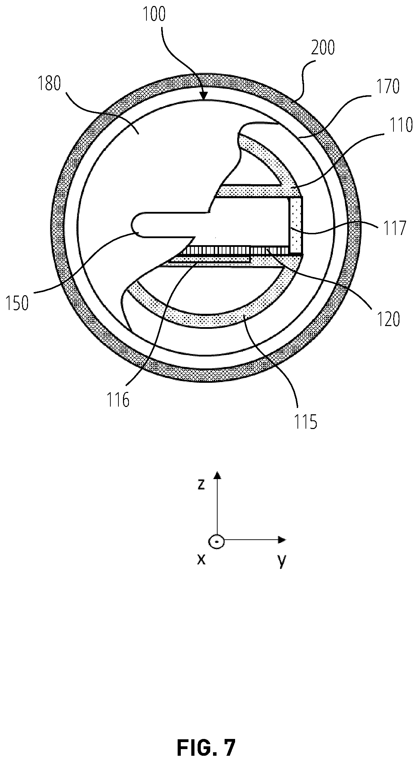

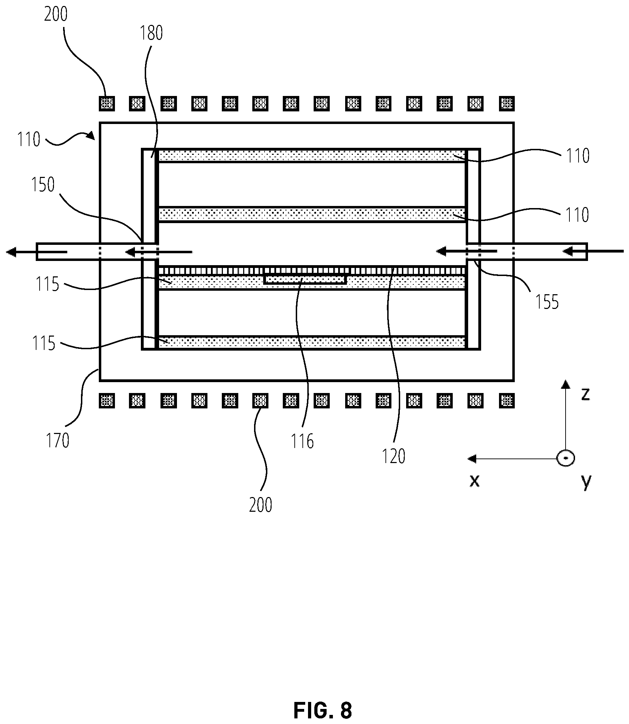

By way of example, in reference to FIG. 7 and FIG. 8, the reaction chamber 100 is configured for the epitaxial deposition of SiC and extends along a longitudinal direction X, parallel to the flow of process gases (the latter being represented by arrows in FIG. 8). The chamber may comprise an inlet aperture 155 and an outlet aperture 150 adapted to inject and discharge process gases, purging gases, cooling gases, and reactive compositions into and out of the reaction chamber and over a receiving area 116. The latter is adapted to receive a substrate on a substrate holder.

The receiving area 116 may be a recess. It may be configured to allow positioning a substrate holder.

The receiving area may be adapted to rotate the substrate holder during the SiC deposition process.

The chamber may be further equipped with suitable injectors, liners, nozzles, shower heads to favor the entrance and discharge of any and all gases above.

The reaction chamber 100 may have a circular or oval cross section in a transverse plane yz perpendicular to the longitudinal direction x. The chamber may comprise an upper partition 110 and a lower partition 115. Both partitions feature a half-moon shape and are made of graphite. They are separated by two lateral partitions 117 made of polycrystalline SiC and having surface roughness of 0.5 - 1 µm Ra.

The chamber may comprise other parts, such as workpiece 120, which in the illustrated embodiment are covers used to protect the top surface of the lower partition 115 from SiC build-up.

The reaction chamber 100 may further comprise several insulating elements, of which only thermal insulating element 180 is shown.

The reaction chamber 100 may further comprise an enclosure 170. The enclosure may be made of quartz, for instance it may consist of a double wall quartz tube optionally cooled with a cooling fluid such as water.

The reaction chamber 100 may be surrounded by an induction coil 200 wrapped around the quartz enclosure 170. The coil may be configured to heat the top and lower partitions 110 and 115 of the reaction chamber.

Many other variants of the above reaction chamber design may be used in the execution of the present invention.

Under a second aspect, the present invention relates to a SiC reactor 1000 adapted to perform the in-situ etching of silicon carbide accretions deposited on one or more parts a reaction chamber 100, according to any embodiments of the method hereinbefore described, and where the silicon carbide accretion comprises silicon carbide in polycrystalline and/or amorphous form.

The reactor 1000 comprises at least one reaction chamber 100 for the deposition of silicon carbide layers on a substrate, said reaction chamber being provided with at least one gas inlet aperture 155 and at least one gas outlet aperture 150.

Under an embodiment, the reactor 1000 comprises 1-10 reaction chambers 100, for example 1-4 reaction chambers.

An embodiment of the reactor 1000 is schematically depicted in FIG. 9.

According to an embodiment, the reactor 1000 is connected or connectable to a source of Si precursors 1200 and to a source of C precursors 1250. For example, the silicon precursor gas may be a chlorinated compound, preferably dichlorosilane, trichlorosilane or tetrachlorosilane. The carbon precursor gas may be a hydrocarbon, in particular propane or ethylene or acetylene or methane. Other types of precursors may be used.

Other sources (not shown), such as sources for n- and p- doping may be connected or connectable to the reactor. For instance, the n-source may be nitrogen, acetonitrile, pyrrole, ammonia, hydrazine, hydrogen cyanide, methylamine.

The reactor is also connectable or connected to a source of a reactive composition through the gas inlet aperture 155, so that at least a first reactive composition is delivered into the reaction chamber through the inlet aperture 155.

The source of the first reactive composition may comprise a source 1100 of the carrier gas (an inert gas, preferably Ar or He) and a source 1150 of the first reactive gas. Other sources may be present, such as sources for other reactive compositions or other reactive gases, for instance sources of oxidizing or reducing compositions.

With the term "source" it is meant a line for gas or liquid, a cylinder and/or a vessel configured to contain such a gas or liquid.

The reactor 1000 further comprises a heating system 200 adapted to heat the reaction chamber to a temperature of 1450 - 1650 °C or up to 1700°C, which is the typical upper limit for the reaction chamber temperature for the deposition of silicon carbide. Specifically, the heating system 200 should be adapted to heat the reaction to a temperature equal to T_{R}, as hereinbefore defined, in order to perform the etching process of the method according to the invention. It is understood that the actual temperature inside the chamber may differ depending on the chamber design, the heating system, and the number of substrates being treated.

In FIG. 7 and FIG. 8, the heating system is located outside the reaction chamber, but other configurations are possible.

The reactor 1000 further comprises a vacuum system 300 adapted to bring the reaction chamber to a pressure ≤ 1000 mbar, such as within the range of: 50 - 1000 mbar, or any other preferred range disclosed herein.

The vacuum system 300 may comprise at least one pump.

The pump is suitable for (a) depressurizing the reaction chamber 100 and/or (b) flowing exhaust gases (resulting from the deposition and etching processes, and/or or cooling steps), out of the reaction chamber through the outlet aperture 150 and into a scrubber 400. The vacuum system may further comprise at least one valve, preferably a throttle valve upstream of the vacuum pump.

The one or more gas outlets also allow discharging the by-products of the etching process into the scrubber 400.

Advantageously, the reactor described above is adapted to execute the method according to the invention, thereby offering reduced PM times.

Under an embodiment, the reactor 1000 further comprises: a processor 600, an accessible memory, and an in-situ etching program.

The in-situ etching program is stored as a sequence of machine language instructions in the accessible memory and adapted to perform steps A and B of the etching process of the method according to the invention.

The processor 600 is configured or configurable to execute the in-situ etching program, for instance, by actuating controls 700 operating the sources 1100 and 1150 of the reactive gas composition.

The controls 700 may comprise a system of valves, such as throttle valves, pumps, and circuitry able to control the flow rate, timing, and absolute and relative quantity of the carrier gas and of the one or more reactive gases.

The gases used in the etching process or the SiC deposition processes may be combined before entering the reaction chamber 100. They may enter the reaction chamber in one stream. Alternatively, they may enter the reaction chamber in a plurality of streams with different concentrations and/or flow rates depending on their injection point and direction. To this effect, it is possible to use a plurality of inlets. Alternatively, it is possible to use one inlet attached to a liner provided with segregated areas to accommodate separate streams of gas flow, such as described in patent application WO2022053963.

The processor 600 may be configured or configurable to control the vacuum system 300, via one or more valves, such as throttle valves, and circuitry.

The reactor 1000 may optionally comprise a human-machine interface 800, to allow an end user to start the etching process, adjust the relevant parameters, and optionally follow its progress.

Under an embodiment, the reaction chamber 100 of the reactor 1000 is of the hot-wall type and comprises one or more parts made of graphite, optionally coated with monocrystalline or polycrystalline silicon carbide with a rugosity below 6,3 µm Ra, or with pyrolytic graphite, diamond, quartz, and/or boron nitride. These optional coatings have been observed to work particularly well in the execution of the invention.

The heating system 200 of the reactor 1000 may be an induction system.

The reactor may be equipped with a monitoring system 500, adapted to detect/monitor an etching parameter indicative of an endpoint of the etching process and positioned between the downstream end of reaction chamber 100 (after the gas outlet aperture 150) and the scrubber 400 where the exhaust gases are treated.

The processor 600 may be optionally configured or configurable to read and elaborate one or more signals from the monitoring system 500, if present.

The reactor according to the invention may comprise one or more detectors for the detection of one or more reactive gases, where said detectors include means to trigger an alarm or a stop signal to ensure user safety.

It is understood that the reactor according to the invention may include all other elements that are essential or desirable in the industry, such as cabinetry, pipes, actuators, circuits, valves, pumps, powering means, etc.

The subject matter of the present disclosure includes all novel and nonobvious combinations and sub-combinations of the various processes, systems, and configurations, and other features, functions, acts, and/or properties disclosed herein, as well as any and all equivalents thereof.

## Claims

1. A method for etching a silicon carbide accretion from one or more workpieces, the method comprising the steps of:
(I) providing a silicon carbide accretion on one or more workpieces of a reaction chamber of a reactor for the deposition of silicon carbide layers on a substrate, said silicon carbide accretion comprising silicon carbide in polycrystalline and/or amorphous form;
(II) executing at least one cycle of an etching process comprising the steps of:
A. ramping the reaction chamber to preset etching process conditions;
B. etching the silicon carbide accretion;
wherein step A comprises the sub-steps of:
A1. ramping the temperature T_{R} of the reaction chamber to 500 - 1450 °C;
A2. ramping the pressure of the reaction chamber to 50 - 1000 mbar;
wherein step B comprises the sub-step of:
B1. delivering a first reactive composition into the reaction chamber; said first reactive composition comprising one or more reactive gases and a carrier gas;
wherein the carrier gas is an inert gas; and
wherein the one or more reactive gases comprise at least a first reactive gas;
wherein said first reactive gas is a halogen or a halogen compound; and
wherein the molar concentration of the first reactive gas into the carrier gas is 15 - 40%.

2. The method according to claim 1, wherein step A comprises a further sub-step A3 of flowing an inert gas into the reaction chamber.

3. The method according to claim 1 or 2, wherein the etching process further comprises a cooling step C to be executed after step B; the cooling step C comprising the following sub-steps:
C1. adjusting the temperature of the reaction chamber to a value T_{c} < T_{R}, with T_{c} < 1000 °C; and
C2. flowing a cooling gas at a pressure of 100 - 1000 mbar inside the reaction chamber.

4. The method according to any one of claims 1 to 3, further comprising the step (II0) of executing a purging process, wherein the purging process comprises the sub-steps of:
- adjusting the pressure of the reaction chamber to ≤ 1 mbar; and
- flowing an inert gas to reach a pressure of 100 - 1000 mbar inside the reaction chamber;
wherein said purging process is executed 1 - 20 times before step A and/or after step B.

5. The method according to any one of the preceding claims, wherein the carrier gas is chosen from the group consisting of nitrogen, argon, or helium.

6. The method according to any one of the preceding claims, wherein the flow rate of the first reactive gas is 0.5 - 2.3 mol/(s·m²).

7. The method according to any one of the preceding claims, wherein the silicon carbide accretion is obtained as by-product of one or more epitaxial deposition processes of monocrystalline silicon carbide layers on a rotating substrate executed in the reaction chamber of a reactor; said by - product being formed on one or more workpieces of said reaction chamber.

8. The method according to any one of the preceding claims, wherein step (I) is performed by executing one or more epitaxial deposition cycles of monocrystalline silicon carbide layers on a same or different substrates inside a reaction chamber of a reactor, until reaching a predefined total thickness T_{z} of monocrystalline silicon carbide layers deposited, where T_{z} is 10 µm - 2000 µm.

9. The method according to claim 8, wherein the etching process is executed for a duration of 0.10-0.6 minutes per µm of the predefined total thickness T_{z}.

10. The method according to any one of the preceding claims, where in step (I), the one or more workpieces of are made of graphite optionally coated with diamond, quartz, pyrolytic graphite, boron nitride, and/or silicon carbide, where silicon carbide has a rugosity < 6,3 µm Ra.

11. The method according to any one of claims 1 to 10, wherein the first reactive gas is chosen from the group consisting of F₂, ClF, ClF₃, ClF₅, Cl₂, HCl, XeF₂, XeF₄, XeF₆, XeO₃, KrF₂, Br₂, I₂, and HBr.

12. The method according to claim 11, wherein the first reactive gas is chosen from the group consisting of F₂, ClF, ClF₃, and ClF5; and wherein step A1 is executed at a temperature T_{R} of 500-1000 °C.

13. The method according to claim 11, wherein the first reactive gas is chosen from the group consisting of Cl₂, and HCl, and:
- step A1 is executed at a temperature T_{R} of 1000 - 1450 °C; and
- step A2 is executed at a pressure of 50 - 700 mbar.

14. The method according to claim 13, wherein:
- step A1 is executed at a temperature T_{R} of 1150 - 1350 °C; and/or
- step A2 is executed at a pressure of 150 - 700 mbar.

15. The method according to any one of claims 11 to 14, wherein the first reactive composition further comprises a second reactive gas and, preferably, said second reactive gas is an oxidizing agent or a reducing agent.

16. The method according to claim 15, wherein the first reactive gas and the second reactive gas in the first reactive composition are respectively chosen from the group consisting of the pairs: HCl and N₂O, HCl and O₃, HCl and H₂O₂, HCl and O₂, Cl₂ and O₂, Cl₂ and O₃, Cl₂ and H₂O₂, HCL and H₂, and HCl and HF.

17. The method according to claim 16, wherein the molar concentration of the oxidizing agent into the carrier gas is 0. 1-20%.

18. The method according to any one of claims 11-15, wherein step B further comprises the sub-step of:
B2. delivering a second reactive composition into the reaction chamber; said second reactive composition comprising one or more reactive gases and a carrier gas;
wherein the carrier gas is an inert gas; and
wherein the one or more reactive gases comprise at least an oxidizing agent; and
wherein sub-step B2 is conducted before or after sub-step B1.

19. The method according to claim 18, wherein sub-step B2 is conducted after sub-step B1, and the molar concentration of the oxidizing agent into the carrier gas is 0.1 - 20%.

20. The method according to any one of claims 15 or 18-19, wherein the oxidizing agent is chosen from the group consisting of N₂O, NO, N₂O₂, O₂, O₃, and H₂O₂.

21. The method according to any one of the preceding claims,
wherein the reaction chamber comprises at least one monitoring system adapted to monitor an etching parameter indicative of an endpoint of the etching process; and
wherein the etching process further comprises a monitoring step executed at the end of step B and comprising the following sub-steps:
- reading a preset target value of the etching parameter;
- checking the value of the etching parameter against the target value; and
- repeating step B until reaching said target value.

22. The method according to any one of the preceding claims,
wherein said method is executed to etch the silicon carbide accretion from one or more workpieces of a reaction chamber when said reaction chamber is positioned inside the reactor, and
wherein said reaction chamber is provided with at least one gas inlet aperture and at least one gas outlet aperture, and
wherein during step B the first reactive composition is delivered into the reaction chamber through the at least one gas inlet aperture and forms by-products of the etching process, said by-products being discharged through the at least one gas outlet aperture.

23. A reactor for the deposition of silicon carbide layers on a substrate and configured to perform the method according to any of the preceding claims, the reactor comprising:
- at least one reaction chamber, said reaction chamber being provided with at least one gas inlet aperture and at least one gas outlet aperture;
- a heating system adapted to heat the reaction chamber to a temperature up to 1700°C, and specifically to a temperature equal to T_{R};
- a vacuum system adapted to bring the reaction chamber to a pressure ≤ 1000 mbar;
wherein said at least one gas inlet aperture is connectable to a source of the one or more reactive gases and the carrier gas;
wherein said at least one gas outlet aperture is configured to discharge the by-products of the etching process.

24. The reactor according to claim 23, further comprising:
- a processor;
- an accessible memory;
- an in-situ etching program stored as a sequence of machine language instructions in the accessible memory, said program being adapted to perform steps A and B of the method for etching a silicon carbide accretion from one or more workpieces of a reaction chamber;
wherein the processor is configurable to execute the in-situ etching program.
